(19) Europäisches Patentamt
European Patent Office
Office européen des brevets

(11) **EP 3 043 136 A1**

(12) **EUROPEAN PATENT APPLICATION**
published in accordance with Art. 153(4) EPC

(43) Date of publication:
**13.07.2016 Bulletin 2016/28**

(51) Int Cl.:
**F28D 15/02** $^{(2006.01)}$   **H01L 23/373** $^{(2006.01)}$

(21) Application number: **14840639.0**

(22) Date of filing: **01.09.2014**

(86) International application number:
**PCT/JP2014/072938**

(87) International publication number:
**WO 2015/030239 (05.03.2015 Gazette 2015/09)**

(84) Designated Contracting States:
**AL AT BE BG CH CY CZ DE DK EE ES FI FR GB
GR HR HU IE IS IT LI LT LU LV MC MK MT NL NO
PL PT RO RS SE SI SK SM TR**
Designated Extension States:
**BA ME**

(30) Priority: **02.09.2013 JP 2013181650**

(71) Applicant: **NGK Insulators, Ltd.
Nagoya-shi, Aichi-ken 467-8530 (JP)**

(72) Inventors:
• **TOMITA, Takahiro**
  **Nagoya-shi**
  **Aichi 467-8530 (JP)**
• **NAGAI, Kenkichi**
  **Nagoya-shi**
  **Aichi 467-8530 (JP)**
• **KOBAYASHI, Hiroharu**
  **Nagoya-shi**
  **Aichi 467-8530 (JP)**

(74) Representative: **TBK
Bavariaring 4-6
80336 München (DE)**

(54) **THERMAL DIODE**

(57)    Provided is a thermal diode 3 that can be used at room temperature and that easily transfers heat in a certain direction. The thermal diode 3 is formed of a first material 1 as a ceramic material exhibiting thermal conductivity that increases in a certain temperature range of -200°C or higher but 1000°C or lower and a second material 2 exhibiting the thermal conductivity that decreases in the temperature range, the first material 1 and the second material 2 being bonded together. The first material 1 has preferably a microstructure having a characteristic length $L_a$ of 1 nm to 10 $\mu$m.

FIG. 1A

**Description**

Technical Field

The present invention relates to a thermal diode that easily transfers heat in a certain direction, but hardly transfers the heat in a reverse direction thereof.

Background Art

A heat rectifying element is known which transfers heat in one direction and hardly transfers the heat in a reverse direction thereof (see Patent Document 1). The heat rectifying element is formed of a heat insulating wall, a hollow body mounted through the heat insulating wall, and a liquid sealed in the hollow body. The heat rectifying element is configured to pass only heat that transfers toward an upper side from a lower side of the heat insulating wall, under certain conditions.

In addition, a thermal diode is known which includes a container sealed with a liquid contained therein having a low boiling point, the container having upper and lower surfaces formed of a material having high thermal conductivity and sides formed of a material having low thermal conductivity (see Patent Document 2). In a case where a high-heat source is provided on a bottom, the thermal diode transfers heat in a manner of radiating heat when a liquid boils and boiling steam is liquefied by contact with a top. On the other hand, in a case where the high-heat source is provided on the top, since steam pressure increases and thus boiling is suppressed, heat is not transferred. That is, the heat is transferred toward the top from the bottom, but the heat is not transferred in a reverse direction.

Moreover, thermal diodes of Non Patent Documents 1 to 3 are known. The thermal diodes exhibit the function of a thermal diode, which transfers heat in one direction, by a material formed by bonding of (a) a material exhibiting thermal conductivity that increases in a certain temperature range and (b) a material exhibiting thermal conductivity that decreases in a certain temperature range.

In Non Patent Document 1, $La_{1.98N}d_{0.02}CuO_4$ is used as the material (a) and $MnV_2O_4$ is used as the material (b), where a material which undergoes structural phase transition is selected as the material (b).

In Non Patent Document 2, porous Si is used as the material (a), and bulk Si is used as the material (b).

In Non Patent Document 3, an Al-Cu-Fe quasicrystal is used as the material (a), and Si, $Ag_2Te$ is used as the material (b). A disordered metallic material having a narrow gap of 200 meV is selected as the material (a) by focusing on an electron structure, and a semiconductor or an insulator having high Debye temperature is selected as the material (b).

Citation List

Patent Documents

[Patent Document 1] JP-A-61-272591
[Patent Document 2] JP-A-63-263393

Non Patent Documents

[Non Patent Document 1] Applied Physics Express 5 (2012) 027302
[Non Patent Document 2] Physics Letters A 376 (2012) 1641
[Non Patent Document 3] Collected abstracts of Meeting of the Japan Institute of Metals, Vol 152nd Page, ROMNUNNO. 247 (2013)

Summary of the Invention

Problem to be Solved by the Invention

In the techniques of Patent Documents 1 and 2, since evaporation of the liquid is used, the function of a thermal diode is exhibited only in a direction of evaporation of liquid. For example, the function of a thermal diode is not exhibited in a transverse direction or in a direction toward a bottom from a top.

In the techniques of Non Patent Documents 1 and 2, the function of a thermal diode is exhibited at an extremely low temperature. In the technique of Non Patent Document 3, corrosion resistance is low.

An object of the present invention is to provide a thermal diode that can be used at room temperature and easily transfers heat in a certain direction.

Means for Solving the Problem

The present inventors found that the problems can be solved by a thermal diode formed by bonding of a first material as a ceramic material exhibiting thermal conductivity that increases in a certain temperature range of -200°C or higher but 1000°C or lower and a second material exhibiting thermal conductivity that decreases in such a temperature range. That is, according to the present invention, the following thermal diode is provided.

[1] A thermal diode including: a first material as a ceramic material exhibiting thermal conductivity that increases in a certain temperature range of -200°C or higher but 1000°C or lower; and a second material exhibiting the thermal conductivity that decreases in the temperature range, wherein the first material and the second material are bonded together.

[2] The thermal diode according to [1], wherein the first material has a microstructure having a characteristic length $L_a$ of 1 nm to 10 $\mu$m.

[3] The thermal diode according to claim [2], wherein the first material is configured by a composite material in which a dissimilar material is dispersed in a base material, a gap GI between particles of the dissimilar material represents the characteristic length $L_a$ of the microstructure, and the particles of the dissimilar material have a particle size of 1 nm to 1000 nm.

[4] The thermal diode according to [3], wherein when an average value of gaps GI between the particles of the dissimilar material of the first material is defined as $GI_{ave}$, the gaps GI between the particles of the dissimilar material are 0.1 $GI_{ave}$ or more but $50GI_{ave}$ or less.

[5] The thermal diode according to [2], wherein the first material is configured by a porous body, a gap PI between pores in the porous body represents the characteristic length $L_a$ of the microstructure, and a pore diameter is 1 nm to 1000 nm.

[6] The thermal diode according to [5], wherein when an average value of gaps PI between the pores of the first material is defined as $PI_{ave}$, the gaps PI between the pores are $0.1PI_{ave}$ or more but $50PI_{ave}$ or less.

[7] The thermal diode according to [2], wherein the first material is configured by a polycrystal, a particle size "d" of crystal particles represents the characteristic length $L_a$ of the microstructure, and the particle size "d" is 1 nm to 1000 nm.

[8] The thermal diode according to [7], wherein when an average value of particle sizes "d" of the crystal particles of the first material is defined as $d_{ave}$, the particle sizes "d" are $0.1d_{ave}$ or more but $50d_{ave}$ or less.

Effect of the Invention

A thermal diode according to the present invention easily transfers heat in a certain direction, but hardly transfers heat in a reverse direction thereof. In addition, the thermal diode can exhibit the function of a thermal diode at room temperature or higher, and thus heat to be generated in daily life can be effectively utilized. By use of a ceramic material, which exhibits dominant thermal conduction by phonon conduction, as a first material, the shape of the thermal diode or the direction of the thermal conduction can be freely designed. Moreover, corrosion resistance is high.

Brief Description of the Drawings

Fig. 1A is a diagram showing an embodiment of a thermal diode and explaining a case where a first material side has a high temperature.

Fig. 1B is a diagram showing an embodiment of a thermal diode and explaining a case where a second material side has a high temperature.

Fig. 2A is a schematic diagram showing an embodiment of a first material that is a ceramic material configured by a composite material formed by dispersion of a dissimilar material in a base material.

Fig. 2B is a schematic diagram showing an embodiment of a first material that is a ceramic material configured by a porous body.

Fig. 2C is a schematic diagram showing an embodiment of a first material that is a ceramic material configured by a polycrystal.

Fig. 3 is a diagram showing variation of thermal conductivity with temperature of a ceramic material as a first material.

Mode for Carrying out the Invention

Embodiments of the present invention will be described below with reference to the accompanying drawings. The present invention is not limited to the following embodiments, and can be changed, modified, or improved without departing from the scope of the invention.

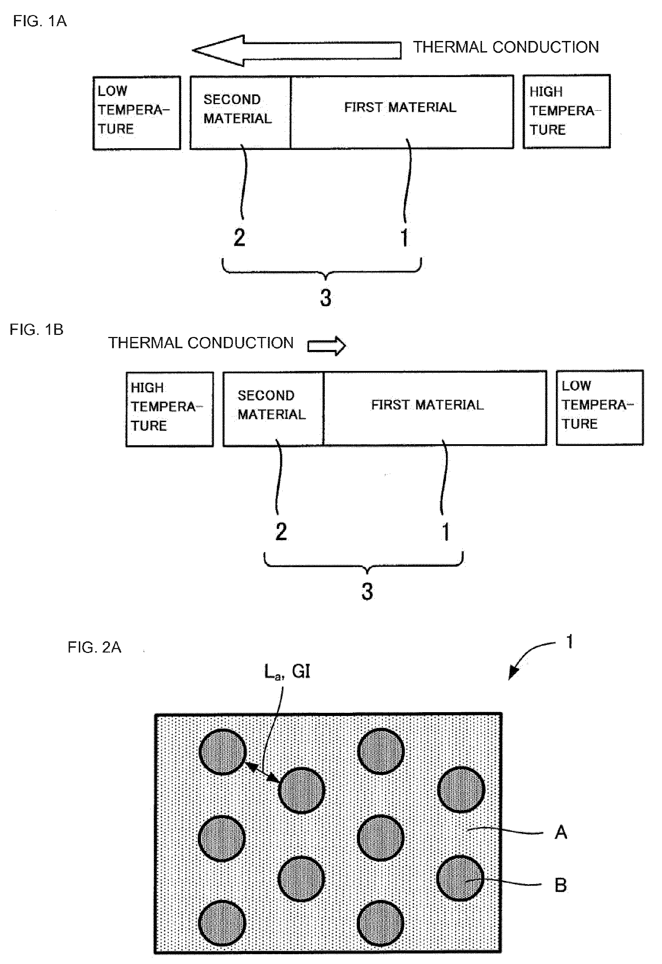

Figs. 1A and 1B show an embodiment of a thermal diode 3 according to the present invention. Fig. 1A is a diagram explaining a case where a first material side has a high temperature. Fig. 1B is a diagram explaining a case where a second material side has a high temperature.

(Thermal diode)

The thermal diode 3 is formed by bonding of a first material 1 as a ceramic material exhibiting thermal conductivity that increases in a certain temperature range of -200°C or higher but 1000°C or lower and a second material 2 exhibiting thermal conductivity that decreases in such a temperature range. By such bonding of the first material 1 and the second material 2, it is possible to form the thermal diode 3 which easily transfers heat in a certain direction.

The thermal diode 3 can exhibit the function of a thermal diode at room temperature or higher. The function of a thermal diode means a function of transferring heat easily in a certain direction but hardly in a reverse direction thereof. Fig. 1A shows that heat is easily transferred when the first material 1 side has a high temperature. Meanwhile, Fig. 1B shows that heat is hardly transferred when the second material 2 side has a high temperature. That is, the thermal diode 3 easily transfers the heat from the first material 1 side to the second material 2 side, but hardly transfers the heat in the reverse direction thereof.

The thermal diode 3 uses a ceramic material as the first material 1, and thus the shape and the direction of thermal conduction can be freely designed (not limited to an evaporation direction of a liquid unlike Patent Documents 1 and 2). Moreover, the thermal diode 3 has high corrosion resistance. The second material 2 is not particularly limited, and examples include a ceramic material and a metal material. The description will be given in detail below.

(First material)

The first material 1 is a ceramic material exhibiting thermal conductivity that increases in a temperature range of -200°C or higher but 1000°C or lower. By the increase of the thermal conductivity in a certain temperature range, it is possible to use the function of a thermal diode in such a temperature range.

A characteristic length $L_a$ of a microstructure in the first material 1 is preferably in a range of 1 nm to 10 $\mu$m. When the characteristic length $L_a$ of the microstructure is in such a range, the material can exhibit the function of diode at a practical temperature (-150°C to 800°C). The characteristic length $L_a$ of the microstructure will be described.

In the first material 1 as a component of the thermal diode 3 of the present invention, when an apparent mean free path ($L_{AMFP}$) of phonon at room temperature is defined by the following Equation 1, the characteristic length $L_a$ of the microstructure is $0.1\ L_{AMFP} \leq L_a \leq 100\ L_{AMFP}$, and the thermal conductivity monotonically increases in a certain temperature range of -200°C or higher but 1000°C or lower:

$$\text{(Equation 1)}\ L_{AMFP} = (3 \times \text{thermal conductivity})/(\text{heat capacity} \times \text{sound velocity}).$$

From a phonon gas model, it has been known that thermal conductivity ($\kappa$) is expressed as Equation 2 to be described below ("Molecular dynamics study of the phonon transport analysis of alloyed silicon crystal", Hori et al., the 49th National Heat Transfer Symposium of Japan, B-341 (2012-5)).
[Mathematical Formula 1]

$$\text{(Equation 2)}$$

$$(C: \text{Specific heat of phonon},\ V: \text{Group velocity of phonon},\ \Lambda: \text{Mean free path of}$$

$$\text{phonon},\ k: \text{Wave number, s: Branch})$$

The apparent mean free path ($L_{AMFP}$) of the phonon is calculated from Equation 1 on the basis of Equation 2.

The thermal conductivity, the heat capacity, and the sound velocity in Equation 1 by which the apparent mean free path of the phonon is calculated indicate values at room temperature of a single crystal of the base material constituting the ceramic material that is the first material 1. The sound velocity is a sound velocity that is transmitted in the single crystal of the base material. That is, for the ceramic material, which is constituted to include a certain material A that is to be the base material, the apparent mean free path ($L_{AMFP}$) of the phonon is calculated by the thermal conductivity, the heat capacity, and the sound velocity at the room temperature where a certain material A is a single crystal.

When the material A is SiC, the $L_{AMFP}$ is 54 nm from Equation 1 [$L_{AMFP}$ = (3 x thermal conductivity)/(heat capacity x sound velocity)]. The following values were used for the calculation: thermal conductivity of SiC of 410 W/mK (Source: "New SiC-based Ceramic Material" (hereinafter, indicating only a book title), edited by 124th committee on High temperature Ceramic Material, Japan Society for the Promotion of Science); density of 3.21 g/cm$^3$ (Source: "new SiC-based ceramic material"); specific heat of 690 J/gK (Source: "new SiC-based ceramic material"); heat capacity of 2215 kJ/m$^3$K (Source: calculated from density and specific heat described in "new SiC-based ceramic material"); and sound velocity of 10360 m/s (Source: JP-A-8-149591).

When the material A is AlN, the $L_{AMFP}$ is 35 nm from Equation 1 [$L_{AMFP}$ = (3 x thermal conductivity)/(heat capacity x sound velocity)]. The following values were used for the calculation: thermal conductivity of AlN of 170 W/mK (Source: WO 2013/061926 A1); density of 3.26 g/cm$^3$ (Source: "Ceramics Dictionary - Second Edition", edited by The Ceramic Society of Japan, Maruzen publishing Co., Ltd.); specific heat of 734 J/gK (Source: "Chemical Reference Book Fundamentals II, 5th Revised Edition", edited by The Chemical Society of Japan, Maruzen Co., Ltd.); heat capacity of 2393 kJ/m$^3$K (calculated from density and specific heat described above); and sound velocity of 6016 m/s (Source: WO 2013/061926 A1).

When the material A is $Si_3N_4$, the $L_{AMFP}$ is 20 nm from Equation 1 [$L_{AMFP}$ = (3 x thermal conductivity)/(heat capacity x sound velocity)]. The following values were used for the calculation; thermal conductivity $Si_3N_4$ of 180 W/mK (Source: "new SiC-based ceramic material" (hereinafter, indicating only a book title), by 124th committee on Advanced Ceramics, Japan Society for the Promotion of Science); density of 3.19 g/cm$^3$ (Source: "new silicon nitride-based material"); specific heat of 710 J/gK (Source: "new silicon nitride-based material"); heat capacity of 2265 kJ/m$^3$K (calculated from density and specific heat described above); and sound velocity of 11780 m/s (Source: JP-A-8-149591).

The phonons and conduction electrons are in charge of the thermal conduction, but the phonons predominate in the ceramic material. Thermal conduction by the phonon is influenced by the structure of the length close to a free path of the phonon. Phonons having a free path longer than the length of the structure are scattered by the structure and hardly transfer heat, but phonons having a shorter free path can transfer heat without being scattered. In this description, the length of the structure represents the characteristic length $L_a$ of the microstructure described above.

The characteristic length $L_a$ of the microstructure is a typical length for representing the microstructure of the ceramic material. For example, the characteristic length $L_a$ represents a gap between particles of the dissimilar material in the case of a composite material in which the dissimilar material is dispersed in the base material, a gap between pores in the case of a porous body, and a crystal particle size (a gap between grain boundaries) in the case of a polycrystal body. When the characteristic length $L_a$ of the microstructure is set to be in a range of 0.1 $L_{AMFP} \leq L_a \leq$ 100 $L_{AMFP}$, it is possible to obtain a material exhibiting the thermal conductivity that largely varies with temperature.

In a material having the characteristic length $L_a$ of the microstructure shorter than the $L_{AMFP}$, an absolute value of the thermal conductivity is low as compared to a material having the characteristic length $L_a$ of the microstructure longer than the $L_{AMFP}$, since phonons to be scattered by the microstructure increase. Furthermore, in the material having the characteristic length $L_a$ of the microstructure shorter than the $L_{AMFP}$, the thermal conduction by phonons greatly varies depending on a temperature, and a difference between the thermal conductivity when a temperature is low and the thermal conductivity when a temperature is high is great as compared to the material having the characteristic length $L_a$ of the microstructure longer than the $L_{AMFP}$. On the other hand, when the characteristic length $L_a$ of the microstructure is set to be smaller than 0.1 $L_{AMFP}$, since the phonons to be scattered by the microstructure excessively increase, the thermal conductivity is not be changed even when the temperature is changed. Therefore, when the characteristic length $L_a$ of the microstructure is shortened in the range of 0.1 $L_{AMFP} \leq L_a <$ $L_{AMFP}$, the absolute value of the thermal conductivity becomes smaller, but a variation ratio of the thermal conductivity with respect to the temperature can be increased. Meanwhile, there is also a case where the characteristic length $L_a$ of the microstructure is more preferably in a range of $L_{AMFP} \leq L_a \leq$ 100 $L_{AMFP}$ to keep a high absolute value of the thermal conductivity.

The free path of the phonon generally has distribution in a range of about 0.1 nm to 1 mm, but when the structure described above is a nano-order structure (in the case of a nanostructure), thermal conduction due to phonons longer than the length of the structure is suppressed. Accordingly, heat is transferred as much as only several percent to several tens percent of original thermal conductivity ($\kappa_{Low}$) of the material at a certain temperature. For this reason, the thermal conductivity is in a low state (for example, 0.2 $\kappa_{Low}$).

Meanwhile, since the free path of phonons becomes shorter as the temperature becomes high, a ratio of the thermal conduction to be suppressed by the nanostructure is reduced at the high temperature. Therefore, the thermal conductivity takes a value (for example, 0.8 $\kappa_{High}$) close to original thermal conductivity ($\kappa_{High}$) of the material at such a temperature.

Here, the extent to which the thermal conduction can be suppressed (for example, in a case where the thermal conductivity is 0.2 $\kappa_{Low}$ at a low temperature, why the thermal conductivity is 0.2) depends on the length of the structure (the characteristic length $L_a$ of the microstructure). Therefore, when the length of the structure is appropriately controlled with reference to the free path of the phonon, the thermal conductivity can be varied by the temperature.

The first material 1 needs to exhibit dominant thermal conduction by phonon conduction, and examples include ceramic in general. Preferable examples of such ceramic include silicon carbide, aluminum nitride, silicon nitride, alumina, yttria, magnesia, mullite, spinel, zirconia, cordierite, and aluminum titanate. In particular, a highly thermally conductive material such as silicon carbide, aluminum nitride, or silicon nitride is preferred because the variation in thermal conductivity with temperature is increased.

The characteristic length $L_a$ of the microstructure varies depending of the material, but is preferably in a range of 1 nm to 10 $\mu$m. The characteristic length $L_a$ of the microstructure is more preferably 1 to 500 nm, and is further preferably 10 to 100 nm. The characteristic length $L_a$ of the microstructure varies depending on the material, but satisfies the following general relation. (1) The length of 1 nm to 10 $\mu$m corresponds to $0.1\,L_{AMFP} \le L_a \le 100\,L_{AMFP}$. In addition, (2) the length of 1 to 500 nm corresponds to $0.1\,L_{AMFP} \le L_a \le 20\,L_{AMFP}$. Moreover, (3) the length of 10 to 100 nm corresponds to $0.3\,L_{AMFP} \le L_a \le 3\,L_{AMFP}$.

Since many phonons are scattered (phonons have a long apparent mean free path) in the length range (2) of 1 to 500 nm as compared to the length range (1) of 1 nm to 10 $\mu$m, the thermal conduction by the phonons is suppressed and thus the thermal conductivity is lowered in the length range (2) rather than the length range (1) at the low temperature, and the thermal conductivity is also reduced in the length range (2) rather than the length range (1) at the high temperature. However, since a ratio of the thermal conduction to be suppressed is smaller at the high temperature due to the microstructure (nanostructure), a variation ratio of the thermal conductivity can be increased in the length range (2) rather than the length range (1), and thus the length range (2) the upper limit of which is restricted is preferred. For example, the thermal conductivity in the length range (1) is 0.2 $\kappa_{Low}$ at the low temperature and 0.8 $\kappa_{High}$ at the high temperature, while the thermal conductivity in the length range (2) is 0.1 $\kappa_{Low}$ at the low temperature and 0.75 $\kappa_{High}$ at the high temperature, and thus, the variation ratio of the thermal conductivity is larger in the length range (2).

Furthermore, in the length range (3) of 10 to 100 nm, since the lower limit is also restricted, the absolute value of the thermal conductivity can be prevented from being reduced too much.

Examples of microstructure control techniques to be applied to the first material 1 include four methods (1) to (4) to be described below. These methods may be combined as appropriate.

(1) Sintering in a state where a material different from a certain material A (base material) is dispersed in the base material with a gap of a characteristic length $L_a$ of a microstructure (Fig. 2A: Embodiment 1).

(2) Precipitating particles of a material different from a certain material A (base material) into the base material with a gap of a characteristic length $L_a$ of a microstructure (Fig. 2A: Embodiment 1).

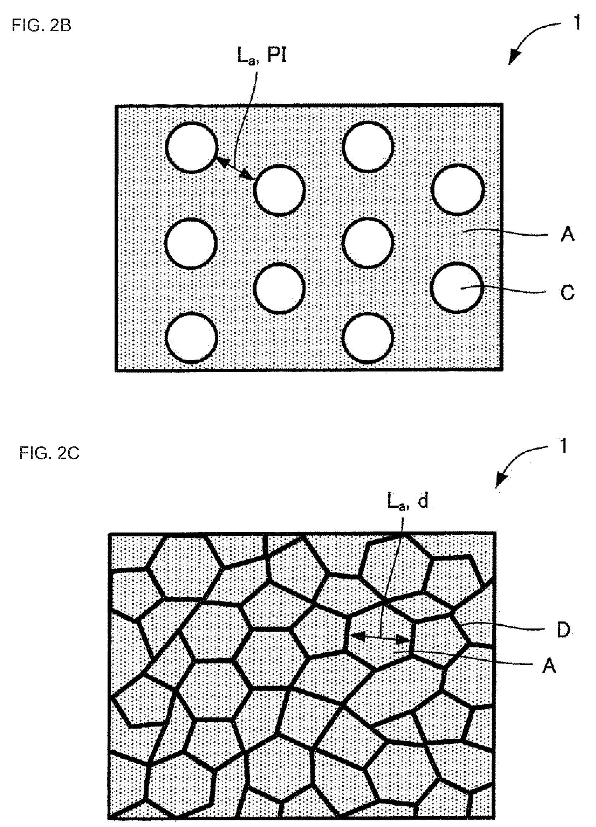

(3) Forming pores in a certain material A (base material) with a gap of a characteristic length $L_a$ of a microstructure (Fig. 2B: Embodiment 2).

(4) A polycrystal body (a grain boundary phase exists with a gap of characteristic length $L_a$ of the microstructure) which is configured by particles of a certain material A having a particle size which is a characteristic length $L_a$ of a microstructure (Fig. 2C: Embodiment 3).

Embodiments 1 to 3 of the first material 1 will be further described.

(Embodiment 1)

Fig. 2A shows Embodiment 1 that is configured by a composite material in which a dissimilar material (material B) is dispersed into a base material (material A) of the first material 1. In this embodiment, a certain gap length exists between particles of the material B provided in the material A. The characteristic length $L_a$ of the microstructure represents a gap between the particles of the material B.

The first material 1 is configured by the composite material in which the dissimilar material is dispersed into the base material, a gap GI between particles of the dissimilar material represents the characteristic length $L_a$ of the microstructure, and a diameter of the dissimilar material particles is preferably 1 nm to 1000 nm.

When the gap between the particles of the dissimilar material (the gap between the particles of the material B) is defined as GI, the GI represents the characteristic length $L_a$ of the microstructure. Among particles $B_i$ existing around a certain particle $B_1$, a particle $B_2$ located at a shortest distance from the particle $B_1$ is selected, and a distance between the particle $B_1$ and the particle $B_2$ is set as the GI. The GI ($= L_a$) is preferably 1 nm to 10 $\mu$m. That is, even when the gaps between the particles of the dissimilar material are distributed (even when the gap is not constant), the GI is preferably within the above range, and 80% or more of all the gaps GI are preferably within this range. When the ceramic material is formed so that the gap GI between the particles of the dissimilar material is within such a range, it is possible to obtain the ceramic material exhibiting the thermal conductivity that largely varies with temperature.

When an average value of gaps GI between the particles of the dissimilar material is defined as $GI_{ave}$, the gaps GI between the particles of the dissimilar material are preferably $0.1 GI_{ave}$ or more but $50 GI_{ave}$ or less. When the ceramic material is formed so that the gaps GI between the particles of the dissimilar material are within such a range, it is possible to easily control the change in thermal conductivity according to a temperature and to obtain the ceramic material exhibiting the thermal conductivity that largely varies with temperature.

Examples of the base material (material A) of the ceramic material as in Embodiment 1 include SiC. Examples of the dissimilar material particles (material B) include materials including at least one selected from the group consisting of O, B, C, N, Al, Si, and Y and specifically include $SiO_2$ or $Al_2O_3$. In order to obtain the desired effect, the ceramic material is formed so that the material B is smaller than the material A in volume ratio. Moreover, when the base material (material A) is SiC, the $GI_{ave}$ is preferably 10 to 500 nm.

By firing of a raw material powder having a predetermined particle size under predetermined firing conditions, it is possible to obtain the ceramic material of Embodiment 1 with controlled gap GI between the particles of the dissimilar material. In addition, by dispersing and separating the raw material powder into primary particles with use of a dispersing agent and subjecting the resulting powder into press molding and firing, variations in gap GI between the particles of the dissimilar material after sintering is reduced.

(Embodiment 2)

Fig. 2B shows an embodiment of the first material 1 that is a ceramic material configured by a porous body. This embodiment has a structure in which a certain gap length exists between pores C provided in the material A. The characteristic length $L_a$ of the microstructure is a structural length which is the gap between the pores C.

The pores C have preferably a pore diameter of 1 nm to 1000 nm.

When a gap between the pores C in the porous body is defined as PI, the PI represents the characteristic length $L_a$ of the microstructure. Among pores $C_i$ existing around a certain pore $C_i$, a pore $C_2$ located at a shortest distance from the pore $C_1$ is selected, and a distance between the pore $C_1$ and the pore $C_2$ is set as the PI. The PI ($= L_a$) is preferably 1 nm to 10 $\mu$m. Even when the gaps between the pores C are distributed (even when the gap is not constant), the PI is preferably within the above range, and 80% or more of all the gaps GI are preferably within this range. When the ceramic material is formed so that the gap PI between the pores C in the porous body is within such a range, it is possible to obtain the ceramic material exhibiting the thermal conductivity that largely varies with temperature.

When an average value of gaps PI between the pores C is defined as $PI_{ave}$, the gaps PI between the pores C are preferably $0.0 PI_{ave}$ or more but $50 PI_{ave}$ or less. When the ceramic material is formed so that the gaps PI between the pores C are within such a range, it is possible to obtain the ceramic material exhibiting the thermal conductivity that largely varies with temperature.

Examples of the ceramic material of Embodiment 2 include a porous body of SiC. In this case, the $PI_{ave}$ is preferably in a range of 10 to 500 nm. When the $PI_{ave}$ is within such a range, the porous body can function as a material exhibiting the function of a thermal diode at a practical temperature (-150°C to 800°C).

By firing of a raw material powder having a predetermined particle size under predetermined firing conditions, it is possible to obtain the ceramic material of Embodiment 2 with controlled gap PI between the pores. In addition, by dispersing and separating the raw material powder into primary particles with use of a dispersing agent and subjecting the resulting powder into press molding and firing, variations in gap PI between the pores after sintering is reduced.

(Embodiment 3)

Fig. 2C shows an embodiment of the first material 1 that is a ceramic material configured by a polycrystal. In this embodiment, a particle size "d" of crystal particles configured by the polycrystal is the characteristic length $L_a$ of the microstructure. The particle size "d" is preferably in a range of 1 nm to 1000 nm. Even when the particle size "d" is distributed (even when the gap is not constant), the particle size "d" is preferably within the above range, and 80% or more of all the particle sizes "d" are preferably within this range. When the ceramic material is formed so that the particle size "d" of the crystal particles is within such a range, it is possible to obtain the ceramic material exhibiting the thermal conductivity that largely varies with temperature.

When an average value of particle sizes "d" of the crystal particles is defined as $d_{ave}$, the particle sizes "d" are preferably $0.1 d_{ave}$ or more but $50 d_{ave}$ or less. When the ceramic material is formed so that the an average value $d_{ave}$ of the particle sizes "d" is within such a range, it is possible to obtain the ceramic material exhibiting the thermal conductivity that largely varies with temperature.

Examples of the ceramic material of Embodiment 3 include a polycrystal body of SiC. In this case, the $d_{ave}$ is preferably in a range of 10 to 500 nm. When the $d_{ave}$ is within such a range, a pair of polycrystals can function as a material exhibiting the function of a thermal diode at a practical temperature (-150°C to 800°C).

By firing of a raw material powder having a predetermined particle size under predetermined firing conditions, it is possible to obtain the ceramic material of Embodiment 3 with controlled particle size "d" of the crystal particles.

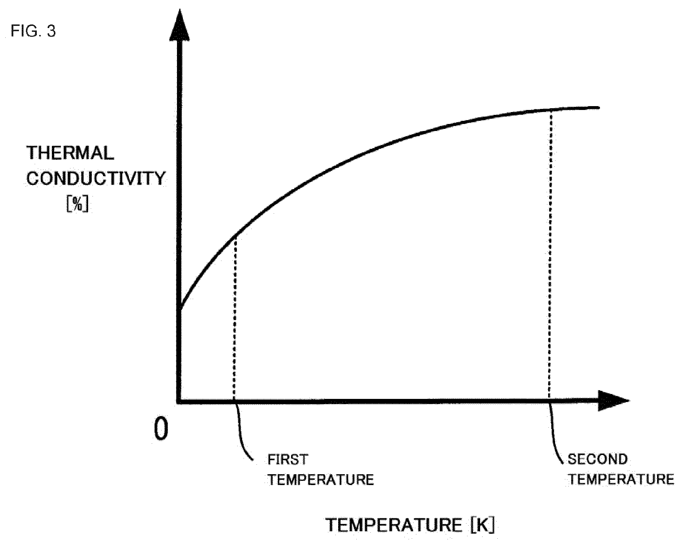

The first material 1 as described above exhibits the thermal conductivity that varies between a first temperature and a second temperature as shown in Fig. 3. The first temperature and the second temperature are a certain temperature of -200°C or higher but 1000°C or lower, and a range between the first temperature and the second temperature corresponds to a "certain temperature range" at which the thermal conductivity of the first material 1 increases. Since the first material 1 exhibits the thermal conductivity that increases with the rising of the temperature, when the first material 1 side has a high temperature (in the case of being equal to or higher than the second temperature), heat is easily transferred to the second material 2 side. In addition, since the first material 1 exhibits a small thermal conductivity at a low temperature, when the first material 1 side has a low temperature (first temperature or lower) and the second material 2 side has a high temperature, heat is hardly transferred with ease from the second material 2 to the first material 1.

(Second material)

The second material 2 needs to be a material exhibiting thermal conductivity that decreases in the temperature range at which the thermal conductivity of the first material 1 increases. Examples of the second material 2 include a ceramic material and a metal material. More specifically, examples of the second material 2 include Si, Ge, CdS, ZnO, GaAs, InP, GaN, SiC, SiGe, and diamond.

(Bonding method)

In the bonding of the first material 1 and the second material 2, various bonding methods can be used. Examples of bonding methods include a welding method such as arc welding, beam welding, resistance welding, thermite welding, or gas welding, liquid phase-solid phase bonding such as brazing or liquid-phase diffusion bonding, solid phase-solid phase bonding such as diffusion bonding, friction welding, hot pressure welding, cold pressure welding, ultrasonic bonding, or heat bonding, bonding by adhesive, and bonding by co-sintering.

Examples

The present invention will be described below in more detail based on Examples, but the present invention is not limited to these Examples.

(Example 1)

(First material)

In order to prepare a formed body having small variation in gap between pores and reduce the variation in the gap between the pores even after sintering, silicon carbide powders having an average particle size of 100 nm were dispersed using ethanol containing a dispersing agent. The silicon carbide powder was subjected to press molding, and thus a disk-like formed body having a diameter of 30 mm and a thickness of 6 mm was prepared. The disk-like formed body was fired at 2050°C under an Ar atmosphere, whereby a porous silicon carbide sintered body was obtained.

This sintered body was observed with an electron microscope, and values for silicon carbide particles, which are components of the sintered body, and pores were measured from the observed image. An average particle size value of 10 silicon carbide particles selected randomly was 100 nm, and an average pore diameter value was 100 nm. In addition, for 10 pores selected randomly, a gap between each pore and a surrounding pore nearest to the pore was measured. The respective pore gaps were 120, 135, 117, 80, 89, 76, 120, 103, 63, and 97 nm, and the average value of the gaps was 100 nm. The respective pore gaps were 0.1 times or more the average value, but were 50 times or less. As described above, it was confirmed that a mean free path of phonon of the SiC was 54 nm and the gap between the pores was 0.1 times or more the mean free path of the phonon, but were 100 times or less.

The thermal conductivity of the sintered body was measured, and the thermal conductivity was 5 W/(m · K) at room temperature, and was 10 W/(m · K) at 200°C. It was confirmed that the thermal conductivity increased in a temperature range of -20°C or higher but 1000°C or lower.

(Second material)

A silicon carbide powder having an average particle size of 5 μm was added with B, C, MgO as an additive agent, and then was subjected to hydrostatic pressing, whereby a rectangular plate of 60 x 60 x 6 mm was prepared.

The rectangular plate was subjected to a HIP treatment for 2 hours at 2000°C under an atmospheric pressure of 2000, whereby a SiC sintered body was obtained.

The thermal conductivity of the sintered body was measured, and the thermal conductivity was 170 W/(m · K) at room temperature, and the thermal conductivity was 106 W/(m · K) at 200°C.

(Bonding)

The first material 1 and the second material 2 were brought into contact with each other, and were bonded to each other by heating at 2000°C.

(Test)

A heat flux $J_1$ in a case where an end face of the first material 1 side was maintained at 227°C and an end face of the second material 2 side was maintained at 27°C was obtained. In addition, a heat flux $J_2$ in a case where an end face of the first material 1 side was maintained at 27°C and an end face of the second material 2 side was maintained at 227°C was obtained. A ratio of the heat flux $J_1$ to heat flux $J_2$ ($J_1/J_2$) was 2. The result is indicated in Table 1. Thus, it was confirmed that the thermal diode 3 easily transfers heat in one direction.

(Example 2)

A thermal diode was prepared in the same manner as in Example 1 except for using the following first material, and was subjected to a test. The obtained result (ratio $J_1/J_2$) is indicated in Table 1.

(First material)

A silicon carbide powder having an average particle size of 20 nm was subjected to press molding, and thus a disk-like formed body having a diameter of 30 mm and a thickness of 6 mm was prepared. The disk-like formed body was fired by a discharge plasma sintering method (1400°C, 10 min.), whereby a porous silicon carbide sintered body was obtained.

This sintered body was observed with an electron microscope, and values for silicon carbide particles, which are components of the sintered body, and pores were measured from the observed image. An average particle size value of 10 silicon carbide particles selected randomly was 30 nm, and an average pore diameter value was 30 nm. In addition, for 10 pores selected randomly, a gap between each pore and a surrounding pore nearest to the pore was measured. The respective pore gaps were 20, 26, 35, 42, 35, 23, 24, 29, 26, and 40 nm, and the average value of the gaps was 30 nm. The respective pore gaps were 0.1 times or more the average value, but were 50 times or less. It was confirmed that the gap between the pores was 0.1 times or more the mean free path of the phonon, but were 100 times or less.

The thermal conductivity of the sintered body was measured, and the thermal conductivity was 4.1 W/(m · K) at room temperature (25°C), 6.3 W/(m · K) at 100°C, and 9.5 W/(m · K) at 200°C. It was confirmed that the thermal conductivity increased in a temperature range of -20°C or higher but 1000°C or lower.

(Example 3)

A thermal diode was prepared in the same manner as in Example 1 except for using the following first material and was subjected to a test. The obtained result (ratio $J_1/J_2$) is indicated in Table 1.

(First material)

A formed body was prepared in the same manner as in Example 2 and the formed body was fired by a discharge plasma sintering method (1400°C, 30 min.), whereby a porous silicon carbide sintered body was obtained.

This sintered body was observed with an electron microscope, and values for silicon carbide particles, which are components of the sintered body, and pores were measured from the observed image. An average particle size value of 10 silicon carbide particles selected randomly was 52 nm, and an average pore diameter value was 55 nm. In addition, for 10 pores selected randomly, a gap between each pore and a surrounding pore nearest to the pore was measured. The respective pore gaps were 64, 50, 46, 42, 35, 68, 70, 56, 63, and 56 nm, and the average value of the gaps was 55 nm. The respective pore gaps were 0.1 times or more the average value but were 50 times or less. It was confirmed that the gap between the pores was 0.1 times or more the mean free path of the phonon but was 100 times or less.

The thermal conductivity of the sintered body was measured, and the thermal conductivity was 7.8 W/(m · K) at room temperature (25°C), 13 W/(m · K) at 100°C, and 16 W/(m · K) at 200°C. It was confirmed that the thermal conductivity increased in a temperature range of -20°C or higher but 1000°C or lower.

(Example 4)

A thermal diode was prepared in the same manner as in Example 1 except for using the following first material and was subjected to a test. The obtained result (ratio $J_1/J_2$) is indicated in Table 1.

(First material)

A formed body was prepared in the same manner as in Example 2 and the formed body was fired by a discharge plasma sintering method (1500°C, 10 min.), whereby a porous silicon carbide sintered body was obtained.

This sintered body was observed with an electron microscope, and values for silicon carbide particles, which are components of the sintered body, and pores were measured from the observed image. An average particle size value of 10 silicon carbide particles selected randomly was 95 nm, and an average pore diameter value was 95 nm. In addition, for 10 pores selected randomly, a gap between each pore and a surrounding pore nearest to the pore was measured. The respective pore gaps were 128, 110, 90, 84, 88, 131, 100, 106, 63, and 80 nm, and the average value of the gaps was 98 nm. The respective pore gaps were 0.1 times or more the average value but were 50 times or less. It was confirmed that the gap between the pores was 0.1 times or more the mean free path of the phonon but was 100 times or less.

The thermal conductivity of the sintered body was measured, and the thermal conductivity was 13 W/(m · K) at room temperature (25°C), 20 W/(m · K) at 100°C, and 28 W/(m · K) at 200°C. It was confirmed that the thermal conductivity increased in a temperature range of -20°C or higher but 1000°C or lower.

(Example 5)

A thermal diode was prepared in the same manner as in Example 1 except for using the following first material and was subjected to a test. The obtained result (ratio $J_1/J_2$) is indicated in Table 1.

(First material)

A formed body was prepared in the same manner as in Example 2 and the formed body was fired under an Ar atmosphere (1400°C, 2 h), whereby a porous silicon carbide sintered body was obtained.

This sintered body was observed with an electron microscope, and values for silicon carbide particles, which are components of the sintered body, and pores were measured from the observed image. An average particle size value of 10 silicon carbide particles selected randomly was 23 nm, and an average pore diameter value was 25 nm. In addition, for 10 pores selected randomly, a gap between each pore and a surrounding pore nearest to the pore was measured. The respective pore gaps were 20, 22, 35, 25, 21, 26, 28, 20, 23, and 30 nm, and the average value of the gaps was 25 nm. The respective pore gaps were 0.1 times or more the average value but were 50 times or less. It was confirmed that the gap between the pores was 0.1 times or more the mean free path of the phonon but was 100 times or less.

The thermal conductivity of the sintered body was measured, and the thermal conductivity was 0.61 W/(m · K) at room temperature (25°C), 0.92 W/(m · K) at 100°C, and 1.3 W/(m · K) at 200°C. It was confirmed that the thermal conductivity increased in a temperature range of -20°C or higher but 1000°C or lower.

(Example 6)

A thermal diode was prepared in the same manner as in Example 1 except for using the following first material and was subjected to a test. The obtained result (ratio $J_1/J_2$) is indicated in Table 1.

(First material)

A formed body was prepared in the same manner as in Example 2, and the formed body was fired under a vacuum (1400°C, 2 h), whereby a porous silicon carbide sintered body was obtained.

This sintered body was observed with an electron microscope, and values for silicon carbide particles, which are components of the sintered body, and pores were measured from the observed image. An average particle size value of 10 silicon carbide particles selected randomly was 22 nm, and an average pore diameter value was 24 nm. In addition, for 10 pores selected randomly, a gap between each pore and a surrounding pore nearest to the pore was measured. The respective pore gaps were 26, 22, 33, 25, 28, 26, 27, 21, 23, and 29 nm, and the average value of the gaps was 26 nm. The respective pore gaps were 0.1 times or more the average value but were 50 times or less. It was confirmed that the gap between the pores was 0.1 times or more the mean free path of the phonon but was 100 times or less.

The thermal conductivity of the sintered body was measured, and the thermal conductivity was 0.53 W/(m · K) at room temperature (25°C), 0.85 W/(m · K) at 100°C, and 1.1 W/(m · K) at 200°C, and it was confirmed that the thermal conductivity increased in a temperature range of -20°C or higher but 1000°C or lower.

(Example 7)

A thermal diode was prepared in the same manner as in Example 1 except for using the following first material and was subjected to a test. The obtained result (ratio $J_1/J_2$) is indicated in Table 1.

(First material)

A formed body was prepared in the same manner as in Example 2, and the formed body was fired by hot pressing (1400°C, 1 h), whereby a porous silicon carbide sintered body was obtained.

This sintered body was observed with an electron microscope, and values for silicon carbide particles, which are components of the sintered body, and pores were measured from the observed image. An average particle size value of 10 silicon carbide particles selected randomly was 57 nm, and an average pore diameter value was 57 nm. In addition, for 10 pores selected randomly, a gap between each pore and a surrounding pore nearest to the pore was measured. The respective pore gaps were 60, 70, 76, 55, 62, 58, 90, 56, 63, and 40 nm, and the average value of the gaps was 63 nm. The respective pore gaps were 0.1 times or more the average value but were 50 times or less. It was confirmed that the gap between the pores was 0.1 times or more the mean free path of the phonon but was 100 times or less.

The thermal conductivity of the sintered body was measured, and the thermal conductivity was 8.2 W/(m · K) at room temperature (25°C), 12 W/(m · K) at 100°C, and 17 W/(m · K) at 200°C. It was confirmed that the thermal conductivity increased in a temperature range of -20°C or higher but 1000°C or lower.

(Example 8)

A thermal diode was prepared in the same manner as in Example 1 except for using the following first material and was subjected to a test. The obtained result (ratio $J_1/J_2$) is indicated in Table 1.

(First material)

A mixture powder obtained in such a manner that each of $Y_2O_3$ and $Al_2O_3$ as a sintering assistant was added by 5 mass% to a silicon carbide powder having an average particle size of 20 nm was subjected to press molding, and thus a disk-like formed body having a diameter of 30 mm and a thickness of 6 mm was prepared. The formed body was fired at 2000°C under an Ar atmosphere, whereby a dense silicon carbide sintered body was obtained.

The sintered body was observed with an electron microscope, and a phase including Al, Y, and O as particles of dissimilar materials in addition to SiC was observed. Values for particles of the dissimilar materials were measured from the electron microscope image. For 10 particles of the dissimilar material selected randomly, a gap between each particle of the dissimilar material and a particle of dissimilar material nearest to the particle was measured. The respective particle gaps of the dissimilar material were 60, 56, 52, 56, 70, 44, 52, 62, 68, and 80 nm, and the average value of the gaps was 60 nm. In addition, an average particle size of the particles of the dissimilar material was 30 nm. The respective particle gaps of the dissimilar material were 0.1 times or more the average value but were 50 times or less. It was confirmed that the gap between the particles of the dissimilar material was 0.1 times or more the mean free path of the phonon but was 100 times or less.

The thermal conductivity of the sintered body was measured, and the thermal conductivity was 18 W/(m · K) at room temperature (25°C), 28 W/(m · K) at 100°C, and 38 W/(m · K) at 200°C. It was confirmed that the thermal conductivity increased in a temperature range of -20°C or higher but 1000°C or lower.

(Example 9)

A thermal diode was prepared in the same manner as in Example 1 except for using the following first material and was subjected to a test. The obtained result (ratio $J_1/J_2$) is indicated in Table 1.

(First material)

A mixture powder obtained in such a manner that each of $SrCO_3$ and $Al_2O_3$ was added by 5 mass% to a silicon carbide powder having an average particle size of 20 nm was subjected to press molding, and thus a disk-like formed body having a diameter of 30 mm and a thickness of 6 mm was prepared. The formed body was fired at 1500°C under an Ar atmosphere, whereby a dense silicon carbide sintered body was obtained.

The sintered body was observed with an electron microscope, and a polycrystal body consisting of SiC and a grain boundary phase including Sr, Al, Si, and O around the SiC was observed. Values for SiC particles were measured from the electron microscope image. Particle sizes of 10 SiC particles selected randomly were measured. The particle sizes were 30, 28, 36, 38, 35, 37, 38, 35, 34, and 39 nm, and the average value of the particle sizes was 35 nm. Each of the particle sizes was 0.1 times or more the average value but was 50 times or less. It was confirmed that the particle size was 0.1 times or more the mean free path of the phonon but was 100 times or less.

The thermal conductivity of the sintered body was measured, and the thermal conductivity was 25 W/(m · K) at room temperature (25°C), 39 W/(m · K) at 100°C, and 55 W/(m · K) at 200°C. It was confirmed that the thermal conductivity increased in a temperature range of -20°C or higher but 1000°C or lower.

(Example 10)

A thermal diode was prepared in the same manner as in Example 1 except for using the following first material and was subjected to a test. The obtained result (ratio $J_1/J_2$) is indicated in Table 1.

(First material)

A silicon carbide powder having an average particle size of 20 nm was subjected to press molding, and thus a disk-like formed body having a diameter of 30 mm and a thickness of 6 mm was prepared. The formed body was fired at 1500°C under an air atmosphere, whereby a dense silicon carbide sintered body was obtained.

The sintered body was observed with an electron microscope, and a polycrystal body consisting of SiC and a grain boundary phase including Si and O around the SiC was observed. Values for SiC particles were measured from the electron microscope image. Particle sizes of 10 SiC particles selected randomly were measured. The particle sizes were 30, 28, 26, 28, 35, 22, 26, 31, 34, and 40 nm, and the average value of the particle sizes was 30 nm. Each of the particle sizes was 0.1 times or more the average value but was 50 times or less. It was confirmed that the particle size was 0.1 times or more the mean free path of the phonon but was 100 times or less.

The thermal conductivity of the sintered body was measured, and the thermal conductivity was 22 W/(m · K) at room temperature (25°C), 35 W/(m · K) at 100°C, and 47 W/(m · K) at 200°C. It was confirmed that the thermal conductivity increased in a temperature range of -20°C or higher but 1000°C or lower.

(Example 11)

A thermal diode was prepared in the same manner as in Example 1 except for using the following first material and was subjected to a test. The obtained result (ratio $J_1/J_2$) is indicated in Table 1.

(First material)

An aluminum nitride powder having an average particle size of 40 nm was subjected to press molding, and thus a disk-like formed body having a diameter of 30 mm and a thickness of 6 mm was prepared. The formed body was fired at 1400°C under a nitrogen atmosphere, whereby a porous aluminum nitride sintered body was obtained.

This sintered body was observed with an electron microscope, and values for aluminum nitride particles, which are components of the sintered body, and pores were measured from the observed image. An average particle size value of 10 aluminum nitride particles selected randomly was 50 nm, and an average pore diameter value was 50 nm. In addition, for 10 pores selected randomly, a gap between each pore and a surrounding pore nearest to the pore was measured. The average value of the gaps was 55 nm. As described above, it was confirmed that a mean free path of phonon of AlN was 35 nm, and the gap between the pores was 0.1 times or more the mean free path of the phonon but was 100 times or less.

The thermal conductivity of the sintered body was measured, and the thermal conductivity was 2 W/(m · K) at room temperature (25°C), 3 W/(m · K) at 100°C, and 4 W/(m · K) at 200°C. It was confirmed that the thermal conductivity increased in a temperature range of -20°C or higher but 1000°C or lower.

(Example 12)

A thermal diode was prepared in the same manner as in Example 1 except for using the following first material and was subjected to a test. The obtained result (ratio $J_1/J_2$) is indicated in Table 1.

(First material)

A silicon nitride powder having an average particle size of 25 nm was subjected to press molding, and thus a disk-like formed body having a diameter of 30 mm and a thickness of 6 mm was prepared. The formed body was fired at 1400°C under a nitrogen atmosphere, whereby a porous silicon nitride sintered body was obtained.

This sintered body was observed with an electron microscope, and values for silicon nitride particles, which are components of the sintered body, and pores were measured from the observed image. An average particle size value of 10 silicon nitride particles selected randomly was 30 nm, and an average pore diameter value was 30 nm. In addition, for 10 pores selected randomly, a gap between each pore and a surrounding pore nearest to the pore was measured. The average value of the gaps was 30 nm. As described above, it was confirmed that a mean free path of phonon of $Si_3N_4$ was 20 nm, and the gap between the pores was 0.1 times or more the mean free path of the phonon but was 100 times or less.

The thermal conductivity of the sintered body was measured, and the thermal conductivity was 2.2 W/(m · K) at room temperature (25°C), 3.3 W/(m · K) at 100°C, and 4.5 W/(m · K) at 200°C. It was confirmed that the thermal conductivity increased in a temperature range of -20°C or higher but 1000°C or lower.

[Table 1]

Example 1

Average value of characteristic length $L_a$ of first material

As indicated in Table 1, Examples 1 to 12 indicated the function of a thermal diode that transfers heat easily in a certain direction but hardly in a reverse direction thereof.

Industrial Applicability

The thermal diode according to the present invention easily transfers heat in one direction, and thus can be used as a member that effectively uses the heat.

Description of Reference Numerals

1: first material,
2: second material,
3: thermal diode.

**Claims**

1. A thermal diode comprising:

a first material as a ceramic material exhibiting thermal conductivity that increases in a certain temperature range of -200°C or higher but 1000°C or lower; and
a second material exhibiting the thermal conductivity that decreases in the temperature range,
wherein the first material and the second material are bonded together.

2. The thermal diode according to claim 1, wherein the first material has a microstructure having a characteristic length $L_a$ of 1 nm to 10 $\mu$m.

3. The thermal diode according to claim 2, wherein the first material is configured by a composite material in which a dissimilar material is dispersed in a base material, a gap GI between particles of the dissimilar material represents the characteristic length $L_a$ of the microstructure, and the particles of the dissimilar material have a particle size of 1 nm to 1000 nm.

4. The thermal diode according to claim 3, wherein when an average value of gaps GI between the particles of the dissimilar material of the first material is defined as $GI_{ave}$, the gaps GI between the particles of the dissimilar material are $0.1GI_{ave}$ or more but $50GI_{ave}$ or less.

5. The thermal diode according to claim 2, wherein the first material is configured by a porous body, a gap PI between pores in the porous body represents the characteristic length $L_a$ of the microstructure, and a pore diameter is 1 nm to 1000 nm.

6. The thermal diode according to claim 5, wherein when an average value of gaps PI between the pores of the first material is defined as $PI_{ave}$, the gaps PI between the pores are $0.1PI_{ave}$ or more but $50PI_{ave}$ or less.

7. The thermal diode according to claim 2, wherein the first material is configured by a polycrystal, a particle size "d" of crystal particles represents the characteristic length $L_a$ of the microstructure, and the particle size "d" is 1 nm to 1000 nm.

8. The thermal diode according to claim 7, wherein when an average value of particle sizes "d" of the crystal particles of the first material is defined as $d_{ave}$, the particle sizes "d" are $0.1d_{ave}$ or more but $50d_{ave}$ or less.

FIG. 1A

FIG. 1B

FIG. 2A

FIG. 2B

FIG. 2C

FIG. 3

## INTERNATIONAL SEARCH REPORT

| | International application No. |
|---|---|
| | PCT/JP2014/072938 |

**A. CLASSIFICATION OF SUBJECT MATTER**
*F28D15/02*(2006.01)i, *H01L23/373*(2006.01)i

According to International Patent Classification (IPC) or to both national classification and IPC

**B. FIELDS SEARCHED**

Minimum documentation searched (classification system followed by classification symbols)
F28D15/02, H01L23/373

Documentation searched other than minimum documentation to the extent that such documents are included in the fields searched

| | | | |
|---|---|---|---|
| Jitsuyo Shinan Koho | 1922–1996 | Jitsuyo Shinan Toroku Koho | 1996–2014 |
| Kokai Jitsuyo Shinan Koho | 1971–2014 | Toroku Jitsuyo Shinan Koho | 1994–2014 |

Electronic data base consulted during the international search (name of data base and, where practicable, search terms used)

**C. DOCUMENTS CONSIDERED TO BE RELEVANT**

| Category* | Citation of document, with indication, where appropriate, of the relevant passages | Relevant to claim No. |
|---|---|---|
| Y<br>A | Jie Ren and Jian-Xin Zhu, Heat diode effect and negative differential thermal conductanceacross nanoscale metal-dielectric interfaces, Physical Review B, Phys. Rev. B 87, 241412(R), 2013.07. 29 | 1-3<br>4-8 |
| Y<br>A | JP 2000-12748 A (Hitachi, Ltd.),<br>14 January 2000 (14.01.2000),<br>claims; paragraphs [0006] to [0011]<br>(Family: none) | 1-3<br>4-8 |
| A | Ryusuke NAKAYAMA, "Al-Cu-Fe Jun Kessho no Ijo Denshi Netsu Dendo-do o Riyo shita Netsu Seiryu Koka", Abstracts of the Japan Institute of Metals (CD-ROM), 152nd, 13 March 2013 (13.03. 2013), ROMBUNNO.247 | 1-8 |

| ☐ Further documents are listed in the continuation of Box C. | ☐ See patent family annex. |
|---|---|

| | |
|---|---|
| * Special categories of cited documents:<br>"A" document defining the general state of the art which is not considered to be of particular relevance<br>"E" earlier application or patent but published on or after the international filing date<br>"L" document which may throw doubts on priority claim(s) or which is cited to establish the publication date of another citation or other special reason (as specified)<br>"O" document referring to an oral disclosure, use, exhibition or other means<br>"P" document published prior to the international filing date but later than the priority date claimed | "T" later document published after the international filing date or priority date and not in conflict with the application but cited to understand the principle or theory underlying the invention<br>"X" document of particular relevance; the claimed invention cannot be considered novel or cannot be considered to involve an inventive step when the document is taken alone<br>"Y" document of particular relevance; the claimed invention cannot be considered to involve an inventive step when the document is combined with one or more other such documents, such combination being obvious to a person skilled in the art<br>"&" document member of the same patent family |

| Date of the actual completion of the international search<br>26 November, 2014 (26.11.14) | Date of mailing of the international search report<br>09 December, 2014 (09.12.14) |
|---|---|
| Name and mailing address of the ISA/<br>Japanese Patent Office | Authorized officer |
| Facsimile No. | Telephone No. |

Form PCT/ISA/210 (second sheet) (July 2009)

## REFERENCES CITED IN THE DESCRIPTION

*This list of references cited by the applicant is for the reader's convenience only. It does not form part of the European patent document. Even though great care has been taken in compiling the references, errors or omissions cannot be excluded and the EPO disclaims all liability in this regard.*

**Patent documents cited in the description**

- JP 61272591 A
- JP 63263393 A
- JP 8149591 A
- WO 2013061926 A1

**Non-patent literature cited in the description**

- *Applied Physics Express,* 2012, vol. 5, 027302
- *Physics Letters A,* 2012, vol. 376, 1641
- *Collected abstracts of Meeting of the Japan Institute of Metals,* 2013, vol. 152nd, 247
- **HORI et al.** Molecular dynamics study of the phonon transport analysis of alloyed silicon crystal. *49th National Heat Transfer Symposium of Japan,* May 2012, vol. B-341
- New SiC-based Ceramic Material. Japan Society for the Promotion of Science
- Ceramics Dictionary. Maruzen publishing Co., Ltd,
- Chemical Reference Book Fundamentals II. The Chemical Society of Japan, Maruzen Co., Ltd,
- new SiC-based ceramic material. Japan Society for the Promotion of Science